# FASCICULE DE BREVET EUROPEEN

(11) **EP 2 546 187 B1**
(45) Date de publication et mention de la délivrance du brevet: **09.08.2017**
(21) Numéro de dépôt: 12175492.3
(22) Date de dépôt: 09.07.2012
(51) Int. Cl.: B81B 7/00

(54) **Structure getter a capacité de pompage optimisée**
Getter-Struktur mit optimierter Pumpkapazität
Getter structure with optimised pumping capacity

(30) Priorité: 11.07.2011 FR 1156302
(43) Date de publication de la demande: 16.01.2013
(73) Titulaire: Commissariat à l'Énergie Atomique et aux Énergies Alternatives, 75015 Paris (FR)
(72) Inventeur: Ferrandon, Christine, 38360 Sassenage (FR); Baillin, Xavier, 38920 Crolles (FR)
(74) Mandataire: Ilgart, Jean-Christophe

(56) Documents cités:
- WO-A1-2008/071906
- US-A1- 2009 261 464

## Description

### DOMAINE TECHNIQUE

La présente invention se rapporte au domaine des structures getter permettant de réaliser une absorption et/ou une adsorption gazeuse.

La structure getter selon l'invention peut être utilisée notamment lors d'une d'encapsulation, ou packaging, sous atmosphère contrôlée d'un ou plusieurs composants, par exemple des microsystèmes, dans une cavité hermétique dont le capot est formé par une couche mince (également appelées PCM pour Packaging Couche Mince) ou par report du capot (WLP pour « Wafer Level Packaging » en anglais).

### ÉTAT DE LA TECHNIQUE ANTÉRIEURE

Certains dispositifs, par exemple des microsystèmes ou composants tels que des MEMS et/ou NEMS ou encore des détecteurs infrarouges, nécessitent pour leur bon fonctionnement d'être encapsulés dans une atmosphère contrôlée (en termes de nature du gaz environnant, de pression, de température, etc.) et durable dans le temps. Lorsqu'un tel dispositif est encapsulé dans une cavité réalisée par report d'un capot sur le substrat, ou support, sur lequel est réalisé le dispositif, l'assemblage entre le capot et le support formant la cavité doit donc être réalisé de façon hermétique afin d'éviter tout échange de gaz entre l'intérieur et l'extérieur de la cavité.

Il existe plusieurs méthodes qui permettent de réaliser un scellement hermétique d'un capot reporté sur un substrat :
- scellement du capot au substrat par l'intermédiaire d'un cordon de pâte de verre appelé « glass-frit » en anglais,
- scellement métallique de type eutectique ou par thermo-compression,
- scellement anodique.

Certains dispositifs nécessitent également d'être encapsulés dans un environnement sous vide, par exemple à une pression comprise entre environ 1 mbar à 10⁻³ mbar selon de type de dispositifs. Au cours du scellement à chaud réalisé entre le capot et le substrat, des molécules gazeuses peuvent être produites lors d'un dégazage ou être volontairement introduites dans la cavité. De plus, pendant la vie du dispositif, d'autres molécules peuvent pénétrer dans la cavité par de fines fuites au niveau de la jonction capot-substrat. Ainsi, il est parfois difficile d'obtenir et/ou de conserver le niveau de vide requis au bon fonctionnement du dispositif.

Afin de résoudre ce type de problèmes, on utilise des matériaux, appelés matériaux getter, qui piègent les molécules de gaz contaminant l'environnement gazeux dans la cavité (par exemple de type H₂O, CO₂, N₂, O₂, H₂, etc.) par réaction chimique avec celles-ci. Un tel matériau getter permet donc de réaliser un pompage gazeux par absorption et/ou adsorption de ces molécules gazeuses. Pour ajuster la pression à l'intérieur de la cavité, il est donc utile d'avoir un matériau getter dont la capacité de pompage soit importante.

Un matériau getter réalise un pompage gazeux après avoir subi un traitement thermique (le matériau getter est chauffé à une certaine température) appelé activation thermique. Lors de ce traitement, les espèces chimiques piégées en surface (notamment de type C, N et O) sont dissoutes par diffusion dans le matériau pour mettre à nu la surface métallique qui est ensuite apte à adsorber d'autres molécules gazeuses. La dissolution dans le matériau par diffusion est thermiquement activée et l'énergie d'activation dépend du mécanisme de diffusion mis en jeu. Ainsi, lorsque la structure du getter est formée d'une pluralité de grains colonnaires de petits diamètres, la diffusion a lieu majoritairement dans les joints de grains. Le flux de matière dépend alors de la densité de joint de grains qui est donc directement reliée à la densité surfacique de grains. Au contraire, lorsque les grains sont de plus grand diamètre, la diffusion a lieu majoritairement au travers des grains. Dans ce dernier cas, l'énergie d'activation est plus importante, donc se produit à plus haute température que la diffusion aux joints de grains. L'activation thermique d'un getter dépend donc intimement de sa microstructure, c'est-à-dire sa structure granulaire. Les getters en couches minces disposent généralement d'une structure colonnaire et le flux de diffusion est contrôlé à la fois par la densité surfacique de grains et par la température. Pour une même température, le flux est donc proportionnel à la densité surfacique de grains.

Il est judicieux d'utiliser un matériau getter dont la température d'activation thermique correspond approximativement à la température à laquelle le scellement entre le capot et le substrat est réalisé. En effet, si le matériau getter a une température d'activation thermique qui est supérieure à celle nécessaire au scellement, il est nécessaire de réaliser, après le scellement, un traitement thermique supplémentaire servant uniquement à réaliser l'activation thermique du matériau getter. Dans le cas contraire, lorsque le matériau getter a une température d'activation thermique qui est inférieure à celle nécessaire au scellement, le matériau getter se retrouve activé thermiquement avant la fin du scellement, provoquant un pompage gazeux par le matériau getter au cours du scellement, ce qui réduit les capacités de pompage du matériau getter une fois le scellement terminé.

Ainsi, cette température d'activation thermique du matériau getter est avantageusement comprise entre environ 400°C et 450°C dans le cas d'un scellement anodique ou par « glass-frit ». Dans le cas d'un scellement métallique, la température d'activation thermique du matériau getter est avantageusement comprise entre environ 350°C et 400°C dans le cas d'une thermo-compression Au/Au, ou comprise entre environ 280°C et 330°C dans le cas de l'utilisation d'un eutectique de type AuSn, et peut descendre jusqu'à être comprise entre environ 200°C et 280°C pour d'autres alliages.

Actuellement, pour couvrir de telles gammes de températures d'activation thermique, les structures getter sont réalisées sous la forme de dépôts multicouches ou sont réalisées en faisant appel à des alliages métalliques particuliers, impliquant des coûts supplémentaires pour la réalisation de telles structures getter.

Le document FR 2 922 202 décrit une structure getter formée d'un empilement d'un matériau getter et d'une sous-couche permettant d'ajuster la température d'activation thermique du matériau getter.

La réalisation d'une telle structure getter implique toutefois la mise en oeuvre de plusieurs étapes de dépôt et de structuration des couches déposées, ce qui augmente également le coût de réalisation d'une telle structure getter.

Le document WO 2008/071906 A1 décrit une structure getter avec deux parties ayant des porosités et des granularités de surface différentes, l'une sur l'autre.

Le document US 2009/0261464 A1 décrit un getter avec une microstructure qui varie sur sa surface.

### EXPOSÉ DE L'INVENTION

Un but de la présente invention est de proposer un nouveau type de structure getter dont le coût de réalisation soit inférieur à celui des structures getter de l'art antérieur, dont la température d'activation thermique peut être modulée (par exemple ajustable entre environ 250°C et 450°C) et pouvant être élaborée dans des conditions standards de dépôt. Ce nouveau type de structure getter peut présenter également, à budget thermique équivalent, une capacité de pompage (absorption et/ou adsorption gazeuse) ajustable, et peut être activable thermiquement pendant le cycle de scellement de la cavité dans laquelle la structure getter est destinée à être encapsulée.

Pour cela, la présente invention propose une structure getter comportant au moins une portion getter disposée sur un support et comprenant au moins deux parties de matériau getter adjacentes d'épaisseurs différentes et dont les densités surfaciques de grains sont différentes l'une par rapport à l'autre.

Les parties de matériau getter de la structure getter sont disposées sur le support l'une à côté de l'autre.

Ainsi, en modulant la proportion des parties d'épaisseurs différentes, et dont les densités surfaciques de grains sont différentes (sur tout ou partie desdites parties de matériau getter), au sein de la portion getter, il est possible de moduler, et notamment de réduire, la température d'activation thermique de la structure getter et/ou de moduler la capacité de pompage de la structure getter.

La « densité surfacique de grains » des parties de matériau getter correspond à la densité des grains colonnaires formant le matériau getter de ces parties.

La structure getter selon l'invention présente donc des propriétés (température d'activation thermique, capacité de pompage) ajustables en fonction du design, ou du dessin, de la structure getter, c'est-à-dire selon la proportion de l'une ou l'autre des deux parties de matériau getter au sein de la portion getter. Ainsi, il est possible de réaliser une structure getter dont la température d'activation thermique peut être comprise entre environ 250°C et 450°C.

De plus, la structure getter selon l'invention peut être réalisée à partir d'un seul matériau getter déposé sous la forme d'une ou plusieurs portions getter, disjointes ou juxtaposées ou se recouvrant, en une seule étape de dépôt sur un même support.

Il est possible de réaliser sur un même support plusieurs structures getter selon l'invention, présentant chacune des propriétés getter (températures d'activation thermique, capacités de pompage) différentes, et pouvant par exemple servir à réaliser des niveaux de vide différents, ou plus généralement différents types d'encapsulation, pour plusieurs composants, par exemple des microsystèmes MEMS ou NEMS, réalisés sur ce support. Ces structures getter peuvent être réalisées à partir d'un même matériau getter déposé en une seule étape à travers un masque, seul le design des ouvertures formées à travers le masque pour réaliser le dépôt du matériau getter à travers ces ouvertures étant différent d'une structure getter à l'autre.

Il est également possible de réaliser, sur un même support, au moins deux structures getter selon l'invention présentant des températures d'activation thermique différentes et servant lors d'une encapsulation d'un seul composant. L'une des structures getter peut présenter une température d'activation thermique approximativement égale à la température mise en jeu lors de l'encapsulation du composant, cette structure getter réalisant un pompage gazeux pendant l'encapsulation.

L'autre structure getter peut présenter une température d'activation thermique supérieure à celle mise en jeu lors de l'encapsulation du composant, et réalisant donc un pompage gazeux ultérieurement à l'encapsulation, déclenché par exemple par chauffage dans un four.

Selon l'invention, il est possible de réaliser plusieurs structures getter activables thermiquement lors de recuits à des températures différentes, ces structures getter étant par exemple destinées à être encapsulées dans une même cavité.

La structure getter selon l'invention est activable thermiquement en un temps raisonnable industriellement, par exemple compris entre environ 30 mn et 120 mn, à une température comprise entre environ 250°C et 450°C.

La portion getter peut comporter au moins une couche de matériau getter. Cette couche de matériau getter peut comporter du titane ou du zirconium.

Lorsque la structure getter comporte plusieurs portions getter, ces portions getter peuvent comporter des matériaux getter différents d'une portion à l'autre.

La couche de matériau getter peut recouvrir au moins une autre couche de matériau de la structure getter. La couche de matériau getter peut notamment recouvrir une ou plusieurs sous-couches de matériau (par exemple composées ou comprenant du titane et/ou du zirconium et/ou du chrome et/ou du platine et/ou du molybdène), ces sous-couches correspondant à des couches supplémentaires d'accroche et/ou d'ajustement de la température d'activation et/ou de getter, comme décrit dans le document FR 2 922 202.

La couche de matériau getter peut être protégée, par exemple par une couche de protection pouvant être composée de ou comprenant du chrome ou du niobium.

Les portions getter peuvent être formées d'une ou plusieurs couches de matériaux getter identiques ou différents.

Les portions de matériau getter peuvent être recouvertes d'une couche de protection, par exemple composée de ou comprenant du chrome ou du niobium et d'épaisseur comprise entre quelques nanomètres et quelques dizaines de nanomètres (< 100 nm). Une telle couche de protection peut être avantageusement déposée juste après le matériau getter et dans le même cycle de vide, ce qui permet de ne pas exposer le matériau getter à une contamination par les espèces qu'il est susceptible de piéger ultérieurement après avoir été activé thermiquement.

Le matériau getter de l'une des deux parties peut comporter des grains de forme sensiblement cylindrique et le matériau getter de l'autre des deux parties peut comporter des grains de forme sensiblement conique et inclinés.

La structure getter peut comporter plusieurs portions getter disposées sur le support selon un motif régulier. Un tel motif régulier peut correspondre par exemple à une matrice formée de plusieurs lignes et plusieurs colonnes de portions getter, ou encore à un alignement selon une direction (par exemple en ligne ou en colonne), ou une disposition en quinconce ou encore en nid d'abeilles des portions getter.

L'une des deux parties de matériau getter de la portion getter peut former une partie centrale comprenant un contour irrégulier et l'autre des deux parties de matériau getter peut former une partie périphérique suivant le contour irrégulier.

L'une des deux parties de matériau getter de la portion getter peut former une première partie centrale d'épaisseur h₁ sensiblement constante et l'autre des deux parties de matériau getter peut former des bords entourant au moins en partie ladite première partie centrale et dont l'épaisseur varie entre l'épaisseur h₁ et une épaisseur h₂ < h₁.

La structure getter peut comporter au moins deux portions de matériau getter disposées l'une à côté de l'autre et se recouvrant en formant, entre deux parties de matériau getter formant des bords, une partie de matériau getter d'épaisseur h₂.

La structure getter peut comporter au moins deux portions getter disposées l'une à côté de l'autre et dont les bords peuvent être juxtaposés, l'épaisseur h₂ pouvant être nulle.

La structure getter peut comporter au moins deux portions getter adjacentes et espacées l'une de l'autre d'une distance non nulle, l'épaisseur h₂ étant nulle.

L'invention concerne également un procédé de réalisation d'une structure getter, comportant au moins une étape de dépôt sur un support d'au moins une portion getter à travers un masque comprenant au moins une ouverture traversant le masque et telle que la portion getter soit déposée à travers l'ouverture du masque, la portion getter pouvant comprendre au moins deux parties de matériau getter adjacentes d'épaisseurs différentes et dont les densités surfaciques de grains, ou microstructures, sont différentes l'une par rapport à l'autre.

Les parties de matériau getter de la structure getter sont disposées sur le support l'une à côté de l'autre.

L'une des deux parties de matériau getter de la portion getter peut former une première partie centrale d'épaisseur h₁ sensiblement constante et l'autre des deux parties de matériau getter peut former des bords entourant au moins en partie ladite première partie centrale et dont l'épaisseur peut varier entre l'épaisseur h₁ et une épaisseur h₂ < h₁, les dimensions et la forme de l'ouverture du masque pouvant correspondre sensiblement aux dimensions et à la forme de la première partie centrale de la portion getter.

Le masque peut comporter au moins une première couche de matériau et une deuxième couche de matériau telles que, lors du dépôt de la portion getter, la première couche de matériau puisse être disposée entre le support et la deuxième couche de matériau, la première et la deuxième couche de matériau comportant chacune au moins une ouverture formant l'ouverture traversant le masque, les dimensions de l'ouverture formée à travers la première couche de matériau pouvant être supérieures aux dimensions de l'ouverture formées à travers la deuxième couche de matériau qui correspondent sensiblement aux dimensions de la première partie centrale de la portion getter.

La première et la deuxième couche du masque peuvent être disposées l'une contre l'autre. L'emploi de films de résine photosensible qui peuvent être rapportés par laminage sur les substrats et dont l'épaisseur peut atteindre une centaine de microns environ peut être mis en oeuvre à cet effet. Un premier film photolithographié peut être recouvert d'un second film de même épaisseur ou d'épaisseur plus faible, lui-même photolithograhié selon des ouvertures de plus petites dimensions que celle du premier film pour définir un masque directement au contact du substrat.

La portion getter peut comporter au moins une couche de matériau getter déposée par évaporation ou par pulvérisation cathodique à travers l'ouverture du masque.

L'invention concerne également un dispositif comportant au moins une cavité hermétique dans laquelle sont encapsulés au moins un composant et au moins une structure getter telle que décrite précédemment.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A, 1B, 4A, 4B, 5A, 5B, 6 et 7 représentent des structures getter, objets de la présente invention, selon différents modes de réalisation ;
- les figures 2A et 2B représentent des portions de matériau getter d'une structure getter, objet de la présente invention, déposées sur un support à travers des ouvertures d'un masque ;
- les figures 3A et 3B représentent schématiquement des masques pouvant être utilisés lors de la réalisation d'une structure getter, objet de la présente invention ;
- la figure 3C représente schématiquement différents types portions de matériau getter d'une structure getter, objet de la présente invention ;
- la figure 8 représente un masque utilisé lors d'un procédé de réalisation d'une structure getter, objet de la présente invention ;
- la figure 9 représente un dispositif comprenant une structure getter, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

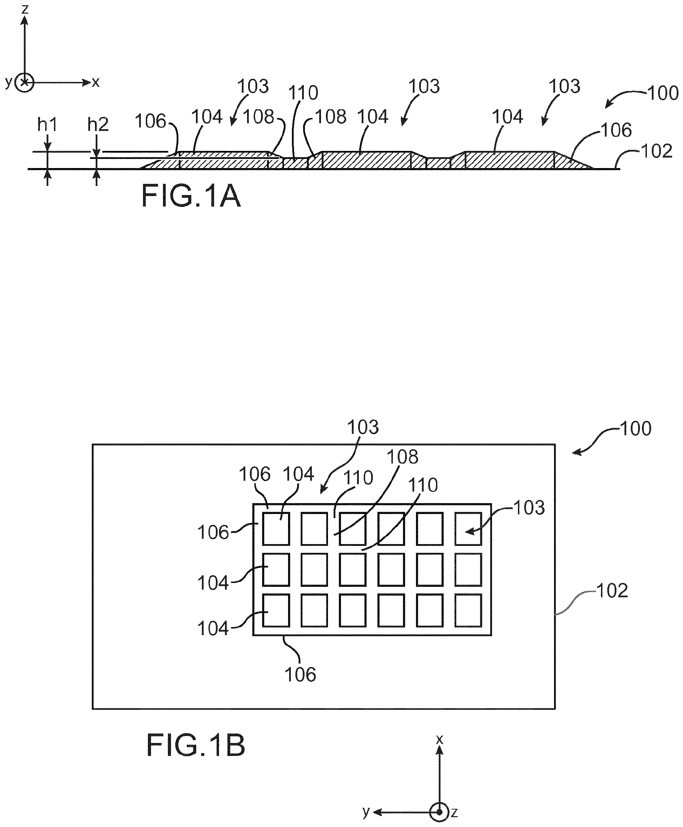

On se réfère aux figures 1A et 1B qui représentent respectivement une vue en coupe de profil et une vue de dessus d'une structure getter 100 selon un premier mode de réalisation.

La structure getter 100 est réalisée sur un support 102, par exemple un substrat composé de semi-conducteur tel que du silicium. La structure getter 100 est formée par une couche de matériau getter présentant des épaisseurs variables sur l'ensemble de la surface de la structure getter 100. La structure getter 100 comporte une pluralité de portions 103, ou îlots, de matériau getter disposées les unes à côté des autres et comportant des bords qui, sur l'exemple des figures 1A et 1B, se recouvrent les uns les autres. Les portions 103 sont par exemple disposées en matrice (3 lignes et 6 colonnes sur l'exemple de la figure 1B). Sur la figure 1B, la structure getter 100 comporte dix-huit portions 103 de matériau getter.

Chaque portion 103 comporte des parties 106 composés de matériau getter formant des bords et dont l'épaisseur décroit depuis une hauteur maximale, appelée h₁, correspondant à l'épaisseur d'une partie centrale rectangulaire 104 de la portion 103. Ainsi, chacune des portions 103 se trouvant en périphérie de la structure getter 100 comporte des bords 106 dont l'épaisseur décroit depuis la hauteur h₁ jusqu'à une hauteur nulle correspondant à la limite, ou à un bord, de la structure getter 100.

Chaque portion 103 comporte également des parties 108 formant des bords qui sont adjacents à d'autres bords de portions 103 adjacentes. L'épaisseur des bords 108 décroît depuis la hauteur h₁ jusqu'à atteindre une partie 110 de matériau getter commune avec une autre portion 103 adjacente, présentant une hauteur h₂ inférieure à h₁ et correspondant à une zone de recouvrement de deux parties 108 formant des bords.

La structure getter 100 est donc formée, dans un plan principal de la structure getter 100 (correspondant à un plan parallèle au plan (X,Y)) d'une succession de parties de matériau getter d'épaisseurs différentes, comme représenté sur la figure 1A. Or, ces différentes parties de matériau getter présentent des microstructures différentes du fait que la structure getter 100 est réalisée par dépôt à travers un masque dont le nombre d'ouvertures correspond au nombre de portions 103 de matériau getter.

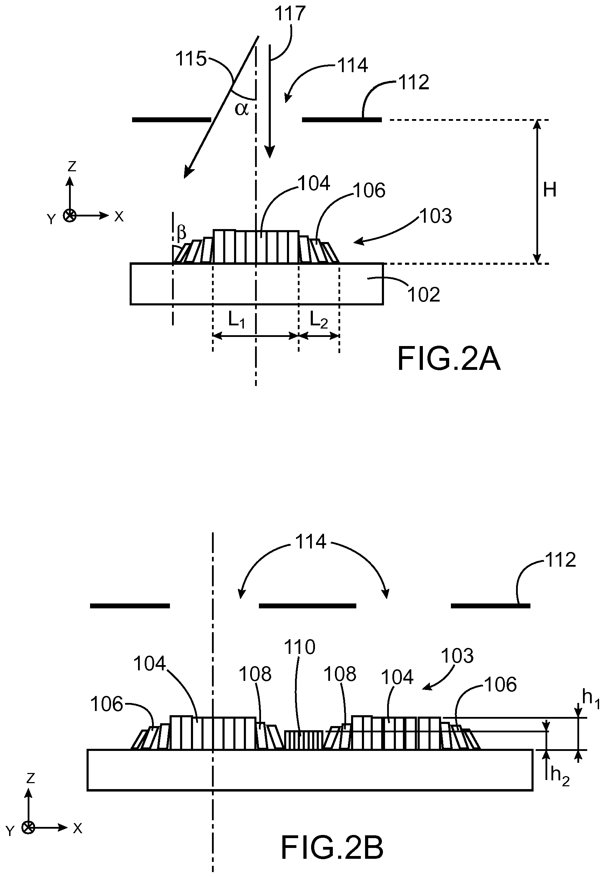

Les figures 2A et 2B représentent schématiquement des portions 103 de matériau getter déposées à travers des ouvertures 114 d'un masque 112.

Les ouvertures 114 sont disposées à une hauteur H du substrat 102. Le dépôt du matériau getter, par exemple réalisé par évaporation sous vide ou par pulvérisation cathodique et avec une vitesse de dépôt égale à environ 10 A/s, à travers les ouvertures 114, du fait de la distance H séparant le masque 112 du substrat 102, entraîne la formation des parties centrales 104 de matériau getter (de largeur L₁) en regard des ouvertures 114 et des parties formant des bords 106 (de largeur L₂) sous les portions du masque 112 adjacentes à l'ouverture 114. Sur l'exemple de la figure 2B, les dimensions des ouvertures 112 sont telles que deux parties 108 formant des bords de deux portions getter 103 adjacentes se recouvrent partiellement pour former une partie commune 110 de matériau getter.

On réalise de préférence un procédé par évaporation pour déposer les portions 103 de matériau getter, car dans ce cas, la porosité intergranulaire des parties 106, 108 correspond à des zones de vide lorsque le dépôt est réalisé sous vide secondaire, c'est-à-dire à une pression inférieure à environ 10⁻⁵ mbar. Cette porosité contribue à augmenter la capacité de pompage du getter. Dans le cas d'un dépôt par pulvérisation cathodique sous pression partielle d'un gaz porteur (Argon ou Krypton par exemple) pour lequel on aura pris soin d'augmenter l'angle α entre les faisceaux incidents et le substrat 102, il est recommandé de réduire les dimensions des parties 108 et d'augmenter celle de la partie 110.

Les valeurs des dimensions L₁ et L₂ dépendent des dimensions de l'ouverture 114, de la valeur de la distance H, de l'angle d'incidence du faisceau de matière lors d'un dépôt par pulvérisation cathodique, et de l'équipement de dépôt utilisé. En faisant varier les dimensions de l'ouverture 114, on fait varier la valeur de L₁ et donc également la valeur d'une surface S₁, dans le plan (X,Y), correspondant à la surface de matériau getter de la partie centrale 104. En considérant que la somme des surfaces des bords 106, 108 correspond à une surface S₂ de matériau getter, la variation des dimensions de l'ouverture 114 entraîne une variation du rapport S₁/S₂ au sein de la portion 103 de matériau getter.

A titre d'exemple, pour une ouverture 114 de masque de géométrie carrée de côté L₁ = 100 µm et de surface S₁ égale à environ 1000 µm², des faisceaux de matière avec un angle α = 2.5° et une distance H égale à environ 500 µm, la longueur L₂ est égale à environ 22 µm. La surface S₂ périphérique est donc de l'ordre de la surface S₁. Pour une disposition en matrice de ces éléments carrés et afin que les parties 106 soient adjacentes, il suffit donc d'utiliser un pochoir dont l'espacement entre les ouvertures carrées soit de dimensions égales à environ 44 µm. Ainsi, avec un masque comportant deux ouvertures 114 de dimensions 100x100 µm² et distantes d'environ 44 µm, on réalise une portion getter comportant deux parties de matériau getter de surface S₁ entourées chacune par une partie de matériau getter de surface S₂ dont la microstructure est différente de celles des parties de surface S₁.

Soit G₁ et G₂ correspondant respectivement, dans une portion getter 103, aux densités surfaciques de grains du matériau getter de la partie centrale 104 et du matériau getter des bords 106, 108. On a alors G₁ inférieur à G₂. En effet, du fait que le flux de matière, lors du dépôt de la portion getter 103, soit plus faible dans les zones ombrées, c'est-à-dire sous le masque 112, en périphérie de l'ouverture 114, on obtient des parties de bords 106, 108 comprenant une densité surfacique de grains G₂ plus importante que celle de la partie centrale 104.

A l'échelle microscopique, pour une même surface de matériau getter, une portion de matériau getter présentant une structure de grains uniforme engendre une température d'activation unique (ou une plage de températures réduite), tandis qu'une portion de matériau getter comprenant une densité de grains plus importante (comme les bords 106 et 108 des portions getter 103) et une structure en colonnes des grains présente une température d'activation qui est réduite et, pour une même épaisseur de getter, une capacité de pompage plus importante. La diffusion des gaz dans l'épaisseur des bords 106 et 108 des portions de matériau getter 103 est donc plus aisée que dans l'épaisseur des parties centrales 104 des portions 103.

En outre, la diffusion des gaz est plus aisée dans la partie commune 110 de matériau getter pour laquelle on s'attend à une densité surfacique de grains la plus élevée, comparativement à la diffusion dans la partie centrale 104.

On voit donc qu'en faisant varier le rapport S₁/S₂ des portions getter 103 getter de la structure 100, on peut faire varier la température d'activation thermique globale de la structure getter 100 ou, à budget thermique identique, faire varier la capacité de pompage de la structure getter 100.

Sur les figures 2A et 2B, on voit que le matériau getter des portions 103 a une structure colonnaire (représentée symboliquement par des rectangles et des cônes sur ces figures). Les parties centrales 104 comportent des grains alignés selon une normale au substrat 102. Par contre, les bords 106 et 108 comportent des grains colonnaires de forme conique et inclinés d'un angle β non nul par rapport à la normale au substrat 102. Cette inclinaison des grains colonnaires des parties de bords 106 et 108 est due au fait que les ouvertures 114 du masque 112 permettent de laisser passer des faisceaux de matière 115 inclinés d'un angle α non nul par rapport à la normale au substrat 102. Ces faisceaux de matière 115 contribuent à la formation des parties de bords 106 et 108, tandis que des faisceaux de matière 117 parallèles à la normale au substrat 102 contribuent à la formation des parties centrales 104. Le document « Glancing angle deposition : Fabrication, properties, and applications of micro- and nanostructured thin films » de M.M. Hawkeye, Journal of Vacuum Science and Technology A: Vacuum, Surfaces and Films, Vol 25(5) Septembre 2007, pages 1317-1335, décrit les techniques de réalisation de microstructures par faisceaux de matière inclinés pouvant être mises en oeuvre pour réaliser la structure getter 100.

La structure des grains des parties centrales 104 est colonnaire et la taille des grains de ces parties de matériau getter dépend du rapport entre les températures de dépôt et de fusion du matériau déposé exprimées en Kelvin et qui est par exemple inférieur à environ 0,3. Les faisceaux de matière qui forment les parties 106 et 108 sont inclinés d'un angle α par rapport à la normale au substrat 102, ce qui donne lieu à la formation de grains inclinés d'un angle β par rapport au substrat 102, dont le diamètre et la hauteur diminuent au fur et à mesure que l'on s'éloigne de la partie centrale 104 alors que l'inclinaison va augmenter. En effet, l'angle β est relié à l'angle α selon la relation tg(α)=2.tg(β). Le phénomène d'ombrage provoque la formation de vides intergranulaires et donne lieu à une structure poreuse. Dans le cas de la partie commune 110, les phénomènes d'ombrage se compensent pour former une structure plus dense que celle des parties 106 et 108, d'épaisseur moindre et de taille de grains inférieure à ceux de la partie centrale 104.

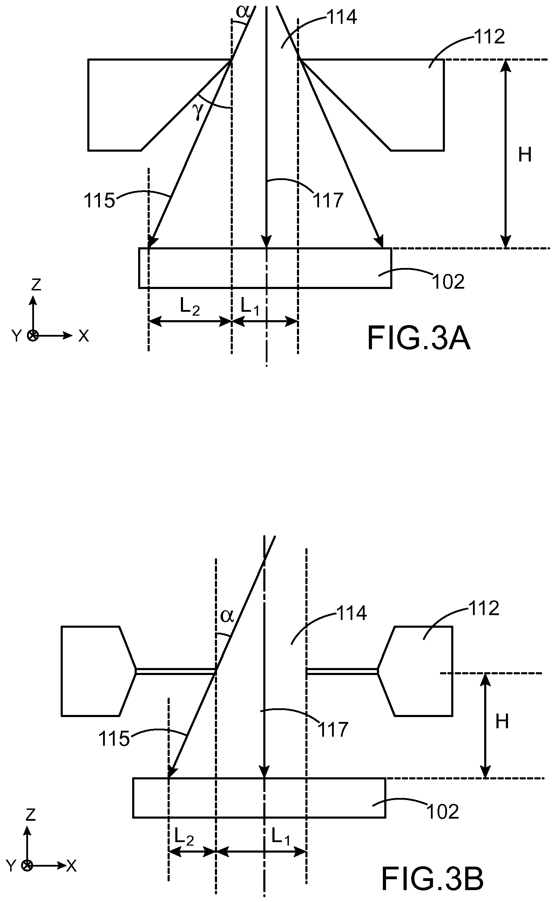

Les figures 3A et 3B représentent les faisceaux 115 et 117 traversant des masques 112 présentant des ouvertures 114 de dimensions différentes, entraînant la formation des portions getter 103 dont les rapports de dimensions L₁ et L₂ sont différents. On voit sur ces figures que la dimension L₁ dépend directement des dimensions de l'ouverture 114, et que la dimension L₂ dépend notamment de l'angle α que peuvent prendre les faisceaux de matière 115 inclinés. On voit également que l'ouverture 114 du masque 112 représenté sur la figure 3A a une forme d'entonnoir (forme un angle γ par rapport à la normale au substrat 102) permettant de présenter une ouverture plus grande pour les faisceaux de matière les plus inclinés. Sur l'exemple de la figure 3B, le masque 112 présente une épaisseur plus faible au niveau de l'ouverture 114 par rapport au reste du masque 112. Sur cet exemple, la distance H entre le masque 112 et le substrat 102 est inférieure à celle de l'exemple de la figure 3A bien que la dimension L₁ soit supérieure à celle de la figure 3A.

Le masque peut présenter plusieurs variantes de dessin selon la valeur de l'angle d'ouverture γ. Cet angle définit l'accessibilité des faisceaux inclinés au niveau de la zone au niveau de laquelle les parties 106, 108 et 110 sont destinées à être réalisées. Plus la valeur de γ est importante, plus L₂ peut être important. La valeur de γ dépend de la géométrie de l'ouverture 114 et de la distance H entre l'ouverture 114 et le substrat 102. Les géométries des masques représentés sur les figures 3A et 3B sont réalisables par des techniques de photolithographie et gravure sur substrat en silicium par exemple. La gravure anisotrope par voie humide (par bain de KOH) permet de définir des plans inclinés dans un substrat monocristallin en silicium, alors que la gravure par voie sèche de type « Deep Reactive Ion Etching » (DRIE) permet de creuser le silicium selon des flans verticaux. Il est également possible d'utiliser ces types de gravure sur un même substrat.

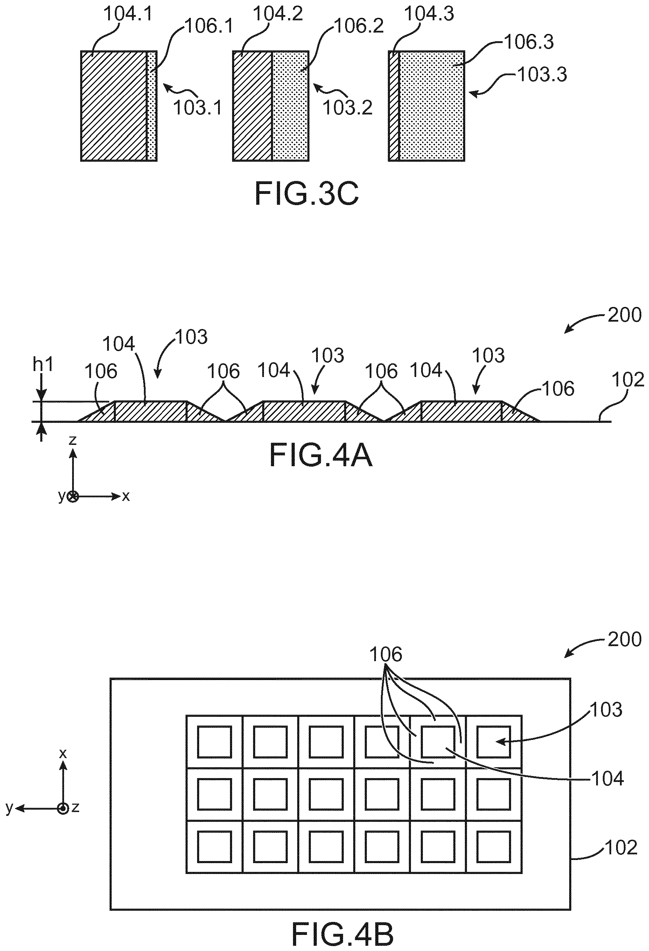

La figure 3C représente des exemples schématiques de répartition des surfaces S₁ et S₂ au sein de portions 103.1, 103.2 et 103.3 de matériau getter et l'influence de ces répartitions sur les températures d'activation thermique de ces portions. Ces portions sont obtenues par un dépôt de titane réalisé par évaporation sous vide secondaire déposé par exemple dans une gamme de vitesse de dépôt de quelques dixièmes de nanomètres par seconde. Pour la portion getter 103.1 dont la surface S₁ représente une majeure partie de la surface totale du matériau getter 103.1 (par exemple S₁/S₂ > 2), la température d'activation thermique de cette portion 103.1 est par exemple égale à environ 400°C. Pour la portion getter 103.2 dont la surface S₁ est approximativement égale à celle de la surface S₂ (par exemple S₁/S₂ = 1), la température d'activation thermique de cette portion 103.1 est par exemple égale à environ 325°C. Enfin, pour la portion getter 103.3 dont la surface S₂ représente une majeure partie de la surface totale du matériau getter 103.3 (par exemple S₁/S₂ < 0,5), la température d'activation thermique de cette portion 103.3 est par exemple égale à environ 250°C.

Dans la structure getter 100 précédemment décrite en liaison avec les figures 1A et 1B, la densité surfacique des grains des parties 110 se trouvant entre deux bords 108 est différente de celles des parties centrales 104 et des bords 106, 108. On a donc, au sein de la structure getter 100, une juxtaposition de parties de matériau getter présentant des microstructures différentes, et notamment des densités surfaciques de grains différentes et donc des températures d'activation thermique différentes.

Les figures 4A et 4B représentent une structure getter 200 selon un deuxième mode de réalisation.

La structure getter 200 comporte le même nombre de portions de matériau getter 103, disposées sous la forme d'une matrice 3×6, que la structure getter 100. Contrairement à la structure getter 100 précédemment décrite en liaison avec les figures 1A et 1B, la structure getter 200 représentée sur les figures 4A et 4B comporte des portions 103 de matériau getter dont les bords 106 de deux portions 103 adjacentes se touchent sans se recouvrir. Ainsi, chaque portion de matériau getter 103 est ici formée d'une portion centrale 104 entourée de quatre bords 106 dont l'épaisseur diminue de h₁ à une hauteur nulle. Dans cette variante de réalisation, la structure getter 100 ne comporte pas de portion de matériau getter 110 de hauteur h₂ et commune à deux portions de matériau getter 103 adjacentes, du fait que les bords 106 de deux portions adjacentes 103 ne se recouvrent pas. Les portions 103 de matériau getter sont juxtaposées.

La structure getter 200 présente donc un rapport S₁/S₂ plus grand que celui de la structure getter 100. Ainsi, pour un matériau getter de même nature, la structure getter 200 présente une température d'activation thermique supérieure à celle de la structure getter 100 ou, à budget thermique équivalent, une capacité de pompage gazeux plus faible que celle de la structure getter 100.

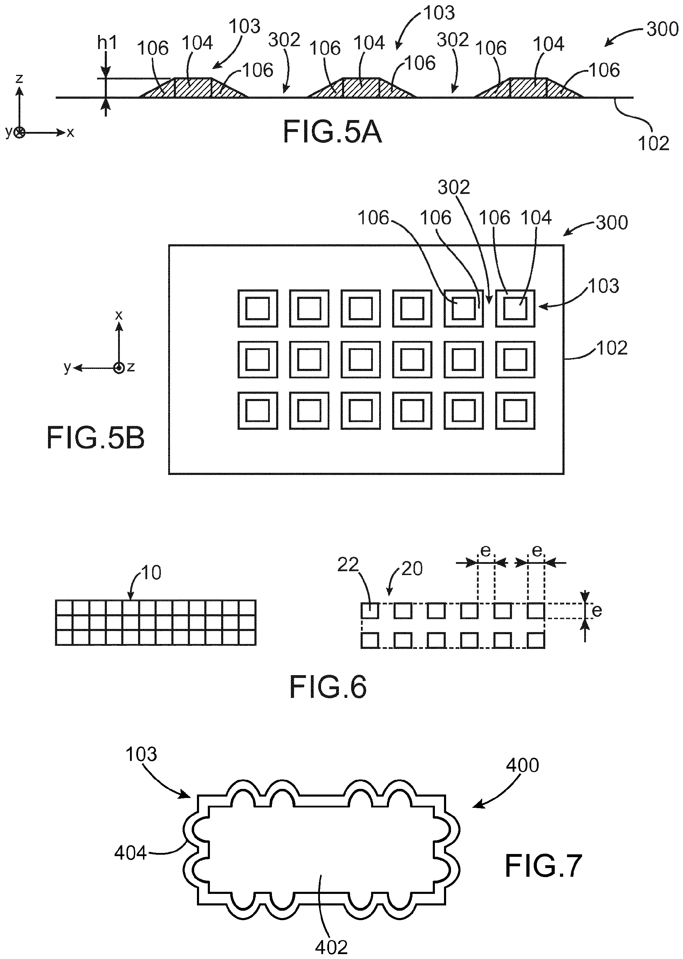

Les figures 5A et 5B représentent une structure getter 300 selon un troisième mode de réalisation.

La structure getter 300 comporte le même nombre de portions (18 au total) de matériau getter 103, disposées sous la forme d'une matrice 3×6, que les structures getter 100 et 200. Comme la structure getter 200, les bords 106 des portions de matériau getter 103 ne se chevauchent pas (il n'y a donc pas les portions 110).

De plus, du fait que les dimensions (telles que la dimension L₁) des parties centrales 104 des portions 103 soient réduites par rapport à celles des portions 103 de la structure getter 200, les bords 106 des portions de matériau getter 103 adjacentes ne se touchent pas et sont séparés par un espace vide 302.

La structure getter 300 présente, pour un même matériau getter, une température d'activation thermique identique à celle de la structure getter 200 ou, à budget thermique équivalent, une capacité de pompage gazeux plus faible que celle de la structure getter 200, puisque la totalité des surfaces S₁ de cette structure getter 300 est inférieure à celle de la structure getter 200.

Les différents exemples des structures getter 100, 200 et 300 décrites précédemment montrent qu'à partir d'un même matériau getter et sur une même surface (les surfaces occupées par les structures getter 100, 200 et 300 sur le substrat 102 sont sensiblement égales), il est possible de réaliser des structures getter présentant des températures d'activation thermique différentes et/ou présentant des capacités de pompage gazeux différentes selon la géométrie des portions de matériau getter 103 formant la structure getter.

Si l'on cherche à réduire la température d'activation thermique d'une structure getter, on peut, pour une même surface, réaliser cette structure getter telle que l'on augmente la périphérie des portions de matériau getter, c'est-à-dire que l'on augmente la longueur totale de bords (le périmètre) de la structure getter dont l'épaisseur varie comme décrit pour les bords 106 ou 108 des structures getter 100, 200 ou 300.

Cette augmentation des bords par rapport au reste du matériau getter peut se faire éventuellement en réduisant la surface totale de matériau getter. La figure 6 illustre ce principe en comparant deux structures getter 10 et 20 occupant une même surface.

La structure getter 10 est formée d'une seule portion rectangulaire de matériau getter occupant une surface S. En considérant que cette surface S correspond à 33 carrés disposés les uns à côté des autres et de côté égal à e, on a donc S = 33×e². Le périmètre P de cette portion rectangulaire de matériau getter est tel que P = 28×e. Pour la structure getter 20, une surface égale à celle occupée par la structure getter 10 n'est plus occupée par une seule portion rectangulaire de matériau getter, mais par 12 portions disjointes de matériau getter 22 de forme carrée et de côté égal à e. La distance séparant deux portions 22 de matériau getter est également égale à e.

Pour cette structure getter 20, la surface de matériau getter S est telle que S = 12×e². Le périmètre P global de la structure getter 20 correspond à la somme des périmètres des portions 22 de matériau getter, et est égal à 48×e. Du fait que le périmètre des portions de matériau getter e de la structure getter 20 soit supérieur à celui des portions de matériau getter de la structure getter 10, la structure getter 20 comporte donc un rapport S₁/S₂ plus petit que celui de la structure getter 10, et donc une température d'activation thermique plus faible que celle de la structure getter 10.

On voit que pour même surface et à partir d'un même matériau getter, il est possible de réaliser des structures getter présentent des températures d'activation thermique différentes et des capacités de pompage gazeux différentes.

Il est possible de réaliser une structure getter comportant plusieurs portions de matériau getter disjointes ou non, dont les bords se recouvrent ou non, afin d'augmenter la proportion de matériau getter formant une partie de matériau getter d'épaisseur variable. Il est également possible que chacune des portions de matériau getter présente des bords irréguliers, ce qui permet de réduire encore plus le rapport S₁/S₂ de la structure getter, et donc de réduire la température d'activation thermique de la structure getter.

Dans les structures getter 100, 200 et 300 précédemment décrites, les portions de matériau getter ont une forme (dans un plan principal de la structure getter) rectangulaire. Dans une variante de réalisation de ces structures getter 100, 200 et 300, les portions de matériau getter 103 peuvent être de forme différente et être réalisées sous la forme de polygones, par exemple sous la forme d'hexagones.

La figure 7 représente un autre exemple de réalisation d'une structure getter 400.

Contrairement aux structures getter 100, 200 et 300 précédemment décrites formées par une pluralité de portions de matériau getter disposées sous la forme d'une matrice, la structure getter 400 comporte une seule portion 103 dont une partie centrale de matériau getter 402 comprend un périmètre qui n'est pas régulier, formant des demi-cercles sur cet exemple. Des parties de bord 404, similaires aux parties 106 précédemment décrites, c'est-à-dire comportant une épaisseur décroissante en s'éloignant de la partie centrale 402, de cette portion getter 103, suivent le périmètre irrégulier de la partie centrale 402.

Ainsi, par rapport à une structure getter de forme rectangulaire et de surface équivalente, la structure getter 400 présente une température d'activation thermique inférieure du fait que son rapport S₁/S₂ soit inférieur à celui de la structure getter de forme rectangulaire et de surface équivalente.

Les portions de matériau getter des structures getter 100, 200, 300 et 400 sont réalisées par dépôt à travers un masque (par exemple similaire au masque 112 précédemment décrit), par exemple un masque dur tel qu'une plaque de silicium trouée, comportant des ouvertures correspondant aux différentes portions de matériau getter à déposer. Un tel masque peut également être à base de résine, réalisé sous la forme d'un film sec d'épaisseur par exemple égale à environ 100 µm. Le masque peut être disposé contre le support sur lequel sont réalisées les portions de matériau getter. Dans ce cas, les dimensions des ouvertures du masque se trouvant du côté de la face du masque disposée contre le support sont supérieures aux dimensions de ces ouvertures au niveau de la face opposée du masque.

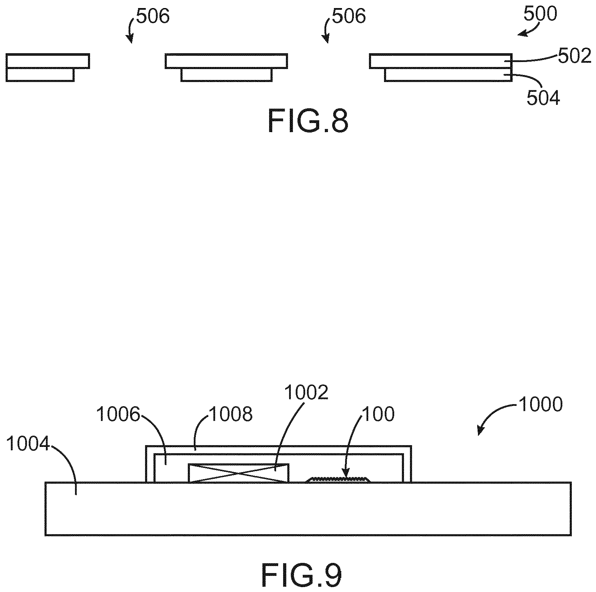

Une partie d'un tel masque 500 est représentée sur la figure 8. Ce masque 500 est formé de deux couches 502, 504, par exemple à base de semi-conducteur, solidarisées l'une contre l'autre. Deux ouvertures 506 formées à travers le masque 500 sont représentées sur la figure 8. On voit que les dimensions d'une ouverture 506 dans la couche inférieure 504 (couche destinée à se trouver du côté de la structure getter réalisée) sont supérieures à celles de cette même ouverture 506 dans la couche supérieure 502. Le motif des ouvertures 506 correspond à la forme des portions de matériau getter à réaliser. Le masque 500 peut être formé de deux couches, ou plus de deux couches, de matériaux, solidarisées ou non les unes aux autres. Ainsi, la couche 504 du masque 500 pourrait être disposée contre le support sur lequel le matériau getter est destiné à être déposé, tandis que la couche 502 peut ne pas être en contact avec la couche 504 et être disposée à une distance H du support, cette distance H étant supérieure à l'épaisseur de la couche 504, lors du dépôt. Les ouvertures 506 de ces couches 502 et 504 peuvent être réalisées par une gravure humide d'un côté et une gravure ionique réactive profonde de l'autre, laissant en fond de gravure un mince film de silicium sur les pourtours des motifs.

Chacune des couches 502, 504 peut également être réalisée par une gravure ionique réactive profonde de petits motifs (par exemple de profondeur égale à environ 100 µm) dans une plaque de semi-conducteur, puis par un collage temporaire de la plaque sur une poignée, un amincissement (par exemple d'environ 80 µm pour une plaque d'épaisseur égale à environ 100 µm), un décollage et un recollage sur une plaque percée avec de gros motifs correspondant à la surface totale du matériau getter à déposer.

Lorsque le masque utilisé pour le dépôt des portions 103 de matériau getter est un film sec à base de résine, il peut être réalisé par laminage d'une ou plusieurs couches de résine, d'épaisseur par exemple égale à une centaine de micromètres, puis insolation et développement avec des conditions particulières.

Lorsque le masque est formé de plusieurs couches de film sec comprenant des ouvertures de dimensions différentes (comme le masque 500 représenté sur la figure 8), des étapes successives de laminage et de photolithographie sont mises en oeuvre pour ces différentes couches.

Après avoir déposé le matériau getter sur le support 102, ce matériau getter peut subir une passivation in-situ, c'est-à-dire une oxydation ou une nitruration par voie sèche, par exemple à une température d'environ 100°C pendant quelques minutes pour une pression de gaz supérieure à environ 10⁻² mbar, mise en oeuvre généralement à la suite du dépôt du matériau getter. Lorsque le masque utilisé pour le dépôt des portions de matériau getter 103 est disposé contre le support 102, le masque est ensuite décollé du support 102 ou bien, lorsqu'il est en résine, le masque peut être retiré par un décapage (« stripping lift-off »).

En alternative à ce procédé de passivation in-situ, le matériau getter peut être protégé par une couche par exemple de chrome ou de niobium, d'une épaisseur de quelques nanomètres à quelques dizaines de nanomètres (par exemple < 100 nm), avantageusement réalisée par un dépôt réalisé juste après celui du matériau getter.

Pour toutes les structures getter précédemment décrites le matériau getter utilisé est par exemple du titane, du zirconium ou du chrome, ou encore un alliage métallique composé d'un ou plusieurs de ces métaux, ou de tout autre matériau ou alliage présentant des propriétés d'absorption et/ou d'adsorption gazeuse.

La figure 9 représente un dispositif 1000 comprenant un microsystème 1002 formé sur un substrat 1004 et encapsulé dans une cavité hermétique 1006 formée entre le substrat 1004 et un capot 1008. Une structure getter, par exemple la structure getter 100 précédemment décrite en liaison avec les figures 1A et 1B, est également encapsulée dans la cavité 1006. La structure getter 100 permet de réaliser un vide, par exemple de 10⁻³ mbar, au sein de la cavité 1006.

Dans une variante, la structure getter encapsulée dans la cavité 1006 pourrait être n'importe laquelle des structures getter précédemment décrites.

De plus, la structure getter pourrait également ne pas être réalisée sur le substrat 1004 mais contre la paroi du capot 1008 destinée à être disposée du côté de la cavité 1006.

## Revendications

1. Structure getter (100, 200, 300, 400) comportant au moins une portion getter (103) disposée sur un support (102, 1004) et comprenant au moins deux parties de matériau getter (104, 106, 108, 110, 402, 404) adjacentes d'épaisseurs différentes et dont les densités surfaciques de grains sont différentes l'une par rapport à l' autre, **caractérisé en ce que** les au moins deux parties de matériau getter (104, 106, 108, 110, 402, 404) adjacentes sont disposées sur le support (102, 1004) l'une à côté de l'autre.

2. Structure getter (100, 200, 300, 400) selon la revendication 1, dans laquelle la portion getter (103) comporte au moins une couche de matériau getter.

3. Structure getter (100, 200, 300, 400) selon la revendication 2, dans laquelle la couche de matériau getter comporte du titane ou du zirconium.

4. Structure getter (100, 200, 300, 400) selon l'une des revendications 2 ou 3, dans laquelle la couche de matériau getter recouvre au moins une autre couche de matériau de la structure getter.

5. Structure getter (100, 200, 300, 400) selon l'une des revendications 2 à 4, dans laquelle la couche de matériau getter est protégée par une couche de protection.

6. Structure getter (100, 200, 300, 400) selon l'une des revendications précédentes, dans laquelle le matériau getter de l'une (104, 110, 402) des deux parties comporte des grains de forme sensiblement cylindrique et le matériau getter de l'autre (106, 108, 404) des deux parties comporte des grains de forme sensiblement conique et inclinés.

7. Structure getter (100, 200, 300, 400) selon l'une des revendications précédentes, comportant plusieurs portions getter (103) disposées sur le support (102, 1004) selon un motif régulier.

8. Structure getter (400) selon l'une des revendications précédentes, dans laquelle l'une des deux parties de matériau getter (402) de la portion getter (103) forme une partie centrale comprenant un contour irrégulier et l'autre des deux parties de matériau getter (404) forme une partie périphérique suivant le contour irrégulier.

9. Structure getter (100, 200, 300, 400) selon l'une des revendications précédentes, dans laquelle l'une des deux parties de matériau getter (104) de la portion getter (103) forme une première partie centrale (104) d'épaisseur h₁ sensiblement constante et l'autre des deux parties de matériau getter (106, 108) forme des bords entourant au moins en partie ladite première partie centrale (104) et dont l'épaisseur varie entre l'épaisseur h₁ et une épaisseur h₂ < h₁.

10. Structure getter (100) selon la revendication 9, comportant au moins deux portions getter (103) disposées l'une à côté de l'autre et se recouvrant en formant, entre deux parties de matériau getter (108) formant des bords, une partie (110) de matériau getter d'épaisseur h₂.

11. Structure getter (200) selon la revendication 9, comportant au moins deux portions getter (103) disposées l'une à côté de l'autre et dont les bords (106) sont juxtaposés, l'épaisseur h₂ étant nulle.

12. Structure getter (300, 400) selon la revendication 9, comportant au moins deux portions getter (103) adjacentes et espacées l'une de l'autre d'une distance non nulle, l'épaisseur h₂ étant nulle.

13. Procédé de réalisation d'une structure getter (100, 200, 300, 400), comportant au moins une étape de dépôt sur un support (102, 1004) d'au moins une portion getter (103) à travers un masque (112, 500) comprenant au moins une ouverture (114, 506) traversant le masque (112, 500) et telle que la portion getter (103) soit déposée à travers l'ouverture (114, 506) du masque (112, 500), la portion getter (103) comprenant au moins deux parties de matériau getter (104, 106, 108, 110, 402, 404) adjacentes et disposées sur le support (102, 1004) l'une à côté de l'autre, d'épaisseurs différentes et dont les densités surfaciques de grains sont différentes l'une par rapport à l'autre.

14. Procédé selon la revendication 13, dans lequel l'une des deux parties de matériau getter (104) de la portion getter (103) forme une première partie centrale (104) d'épaisseur h₁ sensiblement constante et l'autre des deux parties de matériau getter (106, 108) forme des bords entourant au moins en partie ladite première partie centrale (104) et dont l'épaisseur varie entre l'épaisseur h₁ et une épaisseur h₂ < h₁, les dimensions et la forme de l'ouverture (114, 506) du masque (112, 500) correspondant sensiblement aux dimensions et à la forme de la première partie centrale (104) de la portion getter (103).

15. Procédé selon la revendication 14, dans lequel le masque (500) comporte au moins une première couche de matériau (504) et une deuxième couche de matériau (502) telles que, lors du dépôt de la portion getter (103), la première couche de matériau (504) soit disposée entre le support (102) et la deuxième couche de matériau (502), la première et la deuxième couche de matériau (502, 504) comportant chacune au moins une ouverture formant l'ouverture (506) traversant le masque (500), les dimensions de l'ouverture formée à travers la première couche de matériau (504) étant supérieures aux dimensions de l'ouverture formée à travers la deuxième couche de matériau (502) qui correspondent sensiblement aux dimensions de la première partie centrale (104) de la portion getter (103).

16. Procédé selon la revendication 15, dans lequel la première et la deuxième couche (502, 504) du masque (500) sont disposées l'une contre l'autre.

17. Procédé selon l'une des revendications 13 à 16, dans lequel la portion getter (103) comporte au moins une couche de matériau getter déposée par évaporation ou par pulvérisation cathodique à travers l'ouverture (114, 506) du masque (112, 500).

18. Dispositif (1000) comportant au moins une cavité hermétique (1006) dans laquelle sont encapsulés au moins un composant (1002) et au moins une structure getter (100) selon l'une des revendications 1 à 12.

## Patentansprüche

1. Getter-Struktur (100, 200, 300, 400), enthaltend zumindest einen Getter-Abschnitt (103), der an einem Träger (102, 1004) angeordnet ist und zumindest zwei benachbarte Gettermaterial-Teile (104, 106, 108, 110, 402, 404) mit unterschiedlichen Materialstärken enthält, deren Oberflächendichten sich voneinander unterscheiden, **dadurch gekennzeichnet, dass** die zumindest zwei benachbarten Gettermaterial-Teile (104, 106, 108, 110, 402, 404) an dem Träger (102, 1004) nebeneinander angeordnet sind.

2. Getter-Struktur (100, 200, 300, 400) nach Anspruch 1, wobei der Getter-Abschnitt (103) zumindest eine Gettermaterial-Schicht enthält.

3. Getter-Struktur (100, 200, 300, 400) nach Anspruch 2, wobei die Gettermaterial-Schicht Titan oder Zirkonium enthält.

4. Getter-Struktur (100, 200, 300, 400) nach einem der Ansprüche 2 oder 3, wobei die Gettermaterial-Schicht zumindest eine weitere Materialschicht der Getter-Struktur überdeckt.

5. Getter-Struktur (100, 200, 300, 400) nach einem der Ansprüche 2 bis 4, wobei die Gettermaterial-Schicht von einer Schutzschicht geschützt wird.

6. Getter-Struktur (100, 200, 300, 400) nach einem der vorangehenden Ansprüche, wobei das Gettermaterial eines (104, 110, 402) der beiden Teile im Wesentlichen zylinderförmige Körner enthält und das Gettermaterial des anderen (106, 108, 404) der beiden Teile im Wesentlichen kegelförmige und geneigte Körner enthält.

7. Getter-Struktur (100, 200, 300, 400) nach einem der vorangehenden Ansprüche, enthaltend mehrere Getter-Abschnitte (103), die in einem gleichmäßigen Muster an dem Träger (102, 1004) angeordnet sind.

8. Getter-Struktur (400) nach einem der vorangehenden Ansprüche, wobei einer der beiden Gettermaterial-Teile (402) des Getter-Abschnitts (103) einen Mittelteil mit ungleichmäßiger Kontur bildet und der andere der beiden Gettermaterial-Teile (404) einen gemäß der ungleichmäßigen Kontur umlaufenden Teil bildet.

9. Getter-Struktur (100, 200, 300, 400) nach einem der vorangehenden Ansprüche, wobei einer der beiden Gettermaterial-Teile (104) des Getter-Abschnitts (103) einen ersten Mittelteil (104) mit im Wesentlichen konstanter Materialstärke h₁ bildet und der andere der beiden Gettermaterial-Teile (106, 108) die Ränder bildet, die zumindest teilweise den ersten Mittelteil (104) umgeben und deren Materialstärke zwischen der Materialstärke h₁ und einer Materialstärke h₂ < h₁ variiert.

10. Getter-Struktur (100) nach Anspruch 9, enthaltend zumindest zwei Getter-Abschnitte (103), die nebeneinander angeordnet sind und sich überdecken, indem sie zwischen zwei die Ränder bildenden Gettermaterial-Teile (108) einen Teil (110) aus Gettermaterial der Materialstärke h₂ bilden.

11. Getter-Struktur (200) nach Anspruch 9, enthaltend zumindest zwei Getter-Abschnitte (103), die nebeneinander angeordnet sind und deren Ränder (106) nebeneinanderliegen, wobei die Materialstärke h₂ null beträgt.

12. Getter-Struktur (300, 400) nach Anspruch 9, enthaltend zumindest zwei Getter-Abschnitte (103), die benachbart sind und mit einem Abstand ungleich null beabstandet sind, wobei die Materialstärke h₂ null beträgt.

13. Verfahren zum Herstellen einer Getter-Struktur (100, 200, 300, 400), umfassend zumindest einen Schritt des Aufbringens eines Getter-Abschnitts (103) auf einen Träger (102, 1004) durch eine Maske (112, 500) hindurch, die zumindest eine Öffnung (114, 506) aufweist, welche die Maske (112, 500) durchsetzt, derart, dass der Getter-Abschnitt (103) durch die Öffnung (114, 506) der Maske (112, 500) hindurch aufgebracht wird, wobei der Getter-Abschnitt (103) zumindest zwei Gettermaterial-Teile (104, 106, 108, 110, 402, 404) enthält, die benachbart sind und an dem Träger (102, 1004) nebeneinander angeordnet sind, unterschiedliche Materialstärken aufweisen und deren Oberflächendichten sich voneinander unterscheiden.

14. Verfahren nach Anspruch 13, wobei einer der beiden Gettermaterial-Teile (104) des Getter-Abschnitts (103) einen ersten Mittelteil (104) mit im Wesentlichen konstanter Materialstärke h₁ bildet und der andere der beiden Gettermaterial-Teile (106, 108) Ränder bildet, die zumindest teilweise den ersten Mittelteil (104) umgeben und deren Materialstärke zwischen der Materialstärke h₁ und einer Materialstärke h₂ < h₁ variiert, wobei die Abmessungen und die Form der Öffnung (114, 506) der Maske (112, 500) im Wesentlichen den Abmessungen und der Form des ersten Mittelteils (104) des Getter-Abschnitts (103) entsprechen.

15. Verfahren nach Anspruch 14, wobei die Maske (500) zumindest eine erste Materialschicht (504) und eine zweite Materialschicht (502) enthält, derart, dass beim Aufbringen des Getter-Abschnitts (103) die erste Materialschicht (504) zwischen dem Träger (102) und der zweiten Materialschicht (502) angeordnet wird, wobei die erste und die zweite Materialschicht (502, 504) jeweils zumindest eine Öffnung aufweisen, welche die die Maske (500) durchsetzende Öffnung (506) bildet, wobei die Abmessungen der durch die erste Materialschicht (504) hindurch gebildeten Öffnung größer sind als die Abmessungen der durch die zweite Materialschicht (502) hindurch gebildete Öffnung, die im Wesentlichen den Abmessungen des ersten Mittelteils (104) des Getter-Abschnitts (103) entsprechen.

16. Verfahren nach Anspruch 15, wobei die erste und die zweite Schicht (502, 504) der Maske (500) aneinander angeordnet sind.

17. Verfahren nach einem der Ansprüche 13 bis 16, wobei der Getter-Abschnitt (103) zumindest eine Gettermaterial-Schicht enthält, die durch Bedampfung oder Kathodenzerstäubung durch die Öffnung (114, 506) der Maske (112, 500) hindurch aufgebracht ist.

18. Vorrichtung (1000), enthaltend zumindest einen hermetisch dichten Hohlraum (1006), in welchem zumindest ein Bauelement (1002) und zumindest eine Getter-Struktur (100) nach einem der Ansprüche 1 bis 12 eingekapselt sind.

## Claims

1. A getter structure (100, 200, 300, 400) comprising at least one getter portion (103) arranged on a support (102, 1004) and including at least two adjacent getter material parts (104, 106, 108, 110, 402, 404) with different thicknesses and of which the surface grain densities are different from one another, **characterized in that** said at least two adjacent getter material parts (104, 106, 108, 110, 402, 404) are arranged on the support (102, 1004) one next to the other.

2. The getter structure (100, 200, 300, 400) according to claim 1, in which the getter portion (103) comprises at least one getter material layer.

3. The getter structure (100, 200, 300, 400) according to claim 2, in which the getter material layer comprises titanium or zirconium.

4. The getter structure (100, 200, 300, 400) according to one of claims 2 or 3, in which the getter material layer covers at least one other layer of material of the getter structure.

5. The getter structure (100, 200, 300, 400) according to one of claims 2 to 4, in which the getter material layer is protected by a protective layer.

6. The getter structure (100, 200, 300, 400) according to one of the previous claims, in which the getter material of one (104, 110, 402) of the two parts comprises substantially cylindrical grains and the getter material of the other (106, 108, 404) of the two parts comprises substantially conical and inclined grains.

7. The getter structure (100, 200, 300, 400) according to one of the previous claims, comprising a plurality of getter portions (103) arranged on the support (102, 1004) according to a regular pattern.

8. The getter structure (400) according to one of the previous claims, in which one of the two getter material parts (402) of the getter portion (103) forms a central part including an irregular contour, and the other of the two getter material parts (404) forms a peripheral part following the irregular contour.

9. The getter structure (100, 200, 300, 400) according to one of the previous claims, in which one of the two getter material parts (104) of the getter portion (103) forms a first central part (104) with a substantially constant thickness h₁, and the other of the two getter material parts (106, 108) forms edges at least partially surrounding said first central part (104) and of which the thickness varies between the thickness h₁ and a thickness h₂ < h₁.

10. The getter structure (100) according to claim 9, comprising at least two getter portions (103) arranged one next to the other and overlapping, forming, between two getter material parts (108) forming the edges, a getter material part (110) with a thickness h₂.

11. The getter structure (200) according to claim 9, comprising at least two getter portions (103) arranged one next to the other and of which the edges are juxtaposed, with the thickness h₂ being zero.

12. The getter structure (300, 400) according to claim 9, comprising at least two getter portions (103) that are adjacent and spaced apart from one another by a non-zero distance, in which the thickness h₂ is zero.

13. A method for producing a getter structure (100, 200, 300, 400), comprising at least one step of depositing, on a support (102, 1004), at least one getter portion (103) through a mask (112, 500) including at least one opening (114, 506) passing through the mask (112, 500) and such that the getter portion (103) is deposited through the opening (1114, 506) of the mask (112, 500), with the getter portion (103) including at least two adjacent getter material parts (104, 106, 108, 110, 402, 404) arranged on the support (102, 1004) one beside the other, with different thicknesses and of which the surface grain densities are different from one another.

14. The method according to claim 13, in which one of the two getter material parts (104) of the getter portion (103) forms a first central part (104) with a substantially constant thickness h₁ and the other of the two getter material parts (106, 108) forms edges at least partially surrounding said first central part (104) and of which the thickness varies between the thickness h₁ and a thickness h₂ < h₁, with the dimensions and the shape of the opening (114, 506) of the mask (112, 500) corresponding substantially to the dimensions and the shape of the first central part (104) of the getter portion (103).

15. The method according to claim 14, in which the mask (500) comprises at least one first layer of material (504) and one second layer of material (502) so that, when the getter portion (103) is deposited, the first layer of material (504) is arranged between the support (102) and the second layer of material (502), with the first and second layers of material (502, 504) each comprising at least one opening forming the opening (506) passing through the mask (500), with the dimensions of the opening formed through the first layer of material (504) being greater than the dimensions of the opening formed through the second layer of material (502), which correspond substantially to the dimensions of the first central part (104) of the getter portion (103).

16. The method according to claim 15, in which the first and second layers (502, 504) of the mask (500) are arranged one against the other.

17. The method according to one of claims 13 to 16, in which the getter portion (103) comprises at least one getter material layer deposited by evaporation or by cathode sputtering through the opening (114, 506) of the mask (112, 500).

18. A device (1000) comprising at least one hermetic cavity (1006) in which at least one component (1002) and at least one getter structure (100) according to one of claims 1 to 12 are encapsulated.
